(19) Europäisches Patentamt
European Patent Office
Office européen des brevets

(11) EP 2 113 924 A2

(12) **DEMANDE DE BREVET EUROPEEN**

(43) Date de publication:
**04.11.2009 Bulletin 2009/45**

(51) Int Cl.:
***G12B 21/20*** *(2006.01)* ***G01N 13/10*** *(2006.01)*

(21) Numéro de dépôt: **09158265.0**

(22) Date de dépôt: **20.04.2009**

(84) Etats contractants désignés:
**AT BE BG CH CY CZ DE DK EE ES FI FR GB GR HR HU IE IS IT LI LT LU LV MC MK MT NL NO PL PT RO SE SI SK TR**

(30) Priorité: **30.04.2008 FR 0802439**

(71) Demandeur: **Commissariat A L'Energie Atomique C.E.A.**
**75015 Paris (FR)**

(72) Inventeurs:
- **De Crecy, François**
  **38180, SEYSSINS (FR)**
- **Barbe, Jean-Charles**
  **38000, GRENOBLE (FR)**
- **Girardeau-Montaut, Daniel**
  **GRENOBLE, 38000 (FR)**

(74) Mandataire: **Esselin, Sophie et al**
**Marks & Clerk France**
**Conseils en Propriété Industrielle**
**Immeuble " Visium "**
**22, avenue Aristide Briand**
**94117 Arcueil Cedex (FR)**

# (54) Procédé de mesure d'un tenseur anisotrope de diffusion de surface ou des anisotropies de l'énergie de surface

(57) L'invention concerne un procédé de détermination de l'anisotropie du tenseur de diffusion ou de l'anisotropie de l'énergie de surface ne nécessitant pas la réalisation de structures particulières et permettant ce type de détermination dans le cas de perturbations de moyennes amplitudes.

L'invention repose sur la mesure de l'évolution temporelle de rugosités naturelles ou artificielles et de l'analyse des résultats sous forme de densité spectrale de puissance en 2D pour des perturbations dites de moyenne amplitude typiquement caractérisées par des ratio amplitude/longueurs d'onde de perturbation pour une perturbation définie spatialement et présentant deux longueurs d'onde selon deux directions orthogonales, lesdits ratio étant typiquement inférieurs à 0,3.

EP 2 113 924 A2

## Description

Le domaine de l'invention est celui des procédés de mesure des effets dus aux phénomènes de diffusion de surface. Dans certains domaines, il peut être particulièrement intéressant de quantifier des effets de la diffusion de surface, isotropiques et surtout anisotropiques, de matériaux solides.

De nombreuses applications industrielles sont en effet concernées par la quantification de l'anisotropie de la diffusion de surface ou de l'anisotropie de l'énergie de surface ou de tout autre paramètre matériaux pouvant combiner ces deux grandeurs. Citons à titre d'exemples les domaines industriels dans lesquels les problématiques suivantes sont rencontrées :

- Dans le domaine de la métallurgie : rendre lisse une surface afin de diminuer sa sensibilité à certains modes de corrosion chimique ou de diminuer les sites de concentrations de contraintes mécaniques, susceptibles d'initier des fissures ou afin de diminuer la capacité à absorber des particules, des poussières ou des pollutions ;
- Dans le domaine des micro et nano technologies : rendre lisse la surface des semi-conducteurs, ce qui est par exemple important au cours des procédés de fabrication des canaux de transistors MOSFET ; rendre lisse et homogène la surface des différentes couches de matériaux chaque fois que le contrôle de la qualité et l'épaisseur de ces couches est important, par exemple dans le cas des résonateurs à ondes acoustiques (Bulk Acoustic Waves resonators, BAW, en anglais) ; rendre lisse une surface issue d'une fracture, par exemple dans un procédé de fabrication de silicium sur isolant ; fabriquer des canaux ou cavités enterrées à partir de puits ou de tranchées par diffusion de surface...

La diffusion de surface est l'un des quatre modes classiques de transports de la matière au voisinage d'une surface "libre" ou d'une interface (les autres modes de transport sont la diffusion visqueuse, l'évaporation condensation et la diffusion de volume), comme décrit dans l'article W. W. Mullins,"Flattening of a Nearly Plane Solid Surface due to Capillarity", J. of Applied Physics, vol 30, # 1, pp77-83, 1959.

La diffusion de surface, et notamment l'autodiffusion correspondant à la diffusion d'atomes ou de molécules d'un type A sur une surface majoritairement de ce même type A, est généralement considérée comme étant le phénomène prépondérant pour des températures largement inférieures à la température de fusion du matériau.

De manière générale la diffusion de surface est contrôlée par le potentiel chimique $\mu$ (souvent appelé potentiel capillaire) défini par l'équation suivante comme décrit dans l'article de C. Herring, "Surface tension as a motivation for sintering", in "Physics of powder metallurgy", edited by W.E. Kingston, Mc Graw-Hill, 1951 :

$$\mu = \left(\frac{\partial G}{\partial N}\right)_{T,\sigma}$$

où G est l'énergie libre de Gibbs du système, N le nombre d'atomes du système, la dérivation se faisant à température T et contrainte $\sigma$ constantes. En l'absence de champ électromagnétique et de réactions chimiques, l'énergie de Gibbs inclus deux termes, l'un provenant de l'énergie de surface, l'autre de l'énergie élastique de volume :

$$G = \int_{Surface} \gamma \, dS + \int_{Volume} \omega \, dV$$

où $\gamma$ est la densité surfacique d'énergie de surface (usuellement simplement nommée "énergie de surface") et $\omega$ la densité volumique d'énergie élastique. G se réduit au terme surfacique $\int_{Surface} \gamma \, dS$ en considérant par ailleurs que le terme provenant de l'énergie élastique de volume peut être négligé, ce qui est justifié pour des matériaux peu contraints.

On considère généralement que l'énergie de surface ne dépend que de l'orientation de la surface, c'est-à-dire qu'elle n'est pas forcément isotrope. Dans ce cas, et pour des petites perturbations, de nombreux auteurs, dont C. Herring, "Surface tension as a motivation for sintering", in "Physics of powder metallurgy", edited by W.E. Kingston, Mc Graw-Hill, 1951, et E Dornel " Évolution morphologique par diffusion de surface et application à l'étude du démouillage de films minces solides", thèse de l'Université Joseph Fourier, Grenoble, 09/11/2007, ont montré que le potentiel pouvait s'écrire :

$$\mu = \Omega_0{}^*((\kappa_1+\kappa_2)^*\gamma_0 + \kappa_1\,\gamma_1'' + \kappa_2\,\gamma_2'')$$

où $\Omega_0$ est le volume atomique, $K_1$ et $K_2$ sont les deux courbures principales de la surface (comptées positivement quand elles sont vers le matériau), $\gamma_0$ est l'énergie de surface, $\gamma_1$" et $\gamma_2$ " sont les dérivées secondes de l'énergie de surface par rapport à l'orientation de la surface dans les deux directions associées respectivement aux courbures principales $K_1$ et $K_2$ . (Dans le cas d'une surface isotrope, $\gamma_1$" et $\gamma_2$" sont nuls.)

Un flux J de matière se produit en cas de gradient de potentiel, qui s'écrit :

$$J = -\left(\frac{D_s\ n_s}{k_B T}\right)\cdot\nabla_s\mu$$

où $D_s$ est le tenseur de diffusion de surface, $n_s$ est le nombre d'atomes de surface par unité de surface, $k_BT$ est l'énergie thermique et $\nabla_s$ est l'opérateur gradient surfacique. Dans le cas d'une diffusion isotrope, et seulement dans ce cas, $D_s$ est proportionnel à la matrice unité (tenseur diagonal dont tous les termes diagonaux sont égaux) et peut donc être assimilé à un scalaire.

Une grosse difficulté pratique est la mesure de ce tenseur de diffusion. En poursuivant les calculs qui mènent à l'équation d'évolution de la surface comme décrit par W.W. Mullins «: "Theory of thermal Grooving", J. of Applied Physics, Vol 28, N° 3, March 1957 », on peut montrer que plus encore que ce tenseur de diffusion, il est utile de connaître la quantité B définie (dans le cas d'une diffusion isotrope et d'une énergie isotrope) par l'équation suivante :

$$B = \frac{D_s\ \gamma\ n_s\ \Omega_o^2}{k_B T} \qquad \text{en } m^4/s$$

Il existe des méthodes de simulation atomistique pour estimer par simulation ce coefficient de diffusion. Mais ces calculs sont soit très lourds (méthodes "ab-initio"), soit nécessitent (pour les méthodes par "monte Carlo" ou par "dynamique moléculaire", ce qui requiert des modèles de "liaisons fortes" ou pour le moins des potentiels inter-atomiques validés pour chaque cas particulier) des hypothèses difficilement vérifiables ou des calculs préalables "ab-initio" eux aussi très lourds.

Par ailleurs, diverses méthodes ont été proposées pour mesurer également expérimentalement ce coefficient B. Elles s'appliquent souvent uniquement dans le cas d'une diffusion isotrope. Une de ces méthodes, implicitement proposée par W. W. Mullins,"Flattening of a Nearly Plane Solid Surface due to Capillarity", J. of Applied Physics, vol 30, #1, pp77-83, 1959, consiste à graver des rayures ou des sillons sur la surface puis à mesurer l'évolution temporelle du profil transverse du sillon. Cet auteur propose une série d'équations permettant de prédire cette évolution. En inversant ce système, il est possible de remonter au coefficient B.

Une méthode alternative consiste à graver des structures assez simples dans le matériau, par exemple des puits ou des tranchées, et à simuler par des formules analytiques ou par des logiciels scientifiques (par exemple MoveFilm comme décrit par E Dornel " Évolution morphologique par diffusion de surface et application à l'étude du démouillage de films minces solides", thèse de l'Université Joseph Fourier, Grenoble, 09/11/2007, E. Dornel & al, "Surface diffusion dewetting of thin solid films: Numerical methods and application to Si/SiO2", Physical Review B, 73, 115427, 2006), l'évolution de la topologie sous l'effet de la diffusion de surface et par ailleurs de mesurer la vraie surface après qu'elle ait subi la vraie évolution de surface par diffusion (généralement par un recuit en température, sous vide ou sous une atmosphère adaptée) durant un temps mesuré.

En comparant les évolutions de topologies de surface mesurées et simulées, il est généralement possible de remonter à une estimation du coefficient B et donc du coefficient de diffusion $D_s$ si on connaît l'énergie de surface $\gamma$.

Ces méthodes nécessitent la réalisation de structures spéciales, souvent microscopiques, ce qui peut être difficile et coûteux. Le besoin qui se fait sentir est donc d'avoir une méthode simple de caractérisation expérimentale du coefficient de diffusion ou du coefficient B qui ne nécessite pas la réalisation de structures particulières.

De plus, les méthodes décrites précédemment ne s'appliquent pas ou mal au cas où le coefficient de diffusion ou l'énergie de surface sont anisotropes.

Dans ce contexte, la présente invention propose une méthode de détermination des anisotropies du tenseur de diffusion ou des anisotropies de l'énergie de surface ou des anisotropies du coefficient B ne nécessitant pas la réalisation de structures particulières et permettant ce type de détermination dans le cas de perturbations de moyennes

amplitudes.

L'invention repose sur la mesure de l'évolution temporelle de rugosités naturelles ou artificielles et de l'analyse des résultats sous forme de densité spectrale de puissance en 2D pour des perturbations dites de moyenne amplitude typiquement caractérisées par des ratio amplitude/longueurs d'onde de la perturbation pour une perturbation définie spatialement et présentant deux longueurs d'onde selon deux directions orthogonales, lesdits ratio étant typiquement inférieurs à 0.3.

Plus précisément l'invention a pour objet un procédé de mesure d'un tenseur anisotrope de diffusion de surface ou des anisotropies d' énergie de surface, d'une surface définie par une fonction z (x,y) dépendante de deux coordonnées (x,y) selon deux directions orthogonales, d'un matériau, assimilable à la somme d'un ensemble de perturbations dites de moyenne amplitude d'amplitude (a) et de longueurs d'onde ($\lambda_x$, $\lambda_y$), les ratio amplitude/longueurs d'onde ($a/\lambda_x$; $a/\lambda_y$) étant inférieurs à environ 0.3, **caractérisé en ce qu**'il comprend les étapes suivantes :

- une première mesure de la topologie de surface permettant de déterminer la transformée de Fourier spatiale H(fx, fy,0) de cette première topologie à un instant $t_o$=0 pris comme référence du temps, fx et fy étant les fréquences spatiales, c'est-à-dire l'inverse des longueurs d'ondes $\lambda_x$ et $\lambda_y$;
- une étape d'évolution de ladite surface par diffusion de surface ;
- une seconde mesure de la topologie de surface après évolution de ladite surface permettant de déterminer la transformée de Fourier spatiale H(fx,fy,t) de cette seconde topologie à un instant t. fx et fy étant les fréquences spatiales, c'est-à-dire l'inverse des longueurs d'ondes $\lambda_x$ et $\lambda_y$;
- la détermination de composantes du tenseur de diffusion ou des dérivées secondes de l'énergie de surface ou d'une combinaison des deux, permettant de minimiser une mesure de l'écart entre une grandeur H(fx,fy,t) et une grandeur H(fx,fy,0).a(t),

la fonction H(fx,fy,t), étant la transformée de Fourier spatiale d'un ensemble de mesures expérimentales et H (fx,fy,0) a(t) étant défini à partir d'un modèle mathématique basé sur le fait que la demanderesse a montré qu'une perturbation initiale répondant à l'équation suivante:

$$F(x,y,0) = a_0 \cdot \mathrm{Cos}\left[2\pi x.f_x\right] \cdot \mathrm{Cos}\left[2\pi y.f_y\right]$$

évoluait, par l'effet de la diffusion de surface, sous la forme:

$$FM(x,y,t) = a(t) \cdot \mathrm{Cos}\left[2\pi x.f_x\right] \cdot \mathrm{Cos}\left[2\pi y.f_y\right]$$

Avec :

$$a(t) = \frac{a_o}{\sqrt{1 + a_0^2 \alpha_2 \left(\max(f_x;f_y)\right)^2} \cdot \sqrt{\exp\left(\frac{2t}{\tau_{théorique}}\right) - \frac{a_0^2 \alpha_2 \left(\max(f_x;f_y)\right)^2}{1 + a_0^2 \alpha_2 \left(\max(f_x;f_y)\right)^2}}}$$

$\alpha_2$ dépendant de fx et fy, fx et fy étant les fréquences spatiales dans les directions hortogonales associées aux coordonnées x et y.

$$\tau_{\text{théorique}} = \frac{1}{C\left(d_x f_x^2 + d_y f_y^2\right)\left(\left(\gamma_o + \gamma_x''\right).f_x^2 + \left(\gamma_o + \gamma_y''\right).f_y^2\right)}$$

et $d_x$ et $d_y$ : les composantes du tenseur de diffusion de surface dans les deux directions orthogonales associées aux coordonnées x et y, $\gamma_0$ l'énergie de surface et $\gamma_x''$, $\gamma_y''$ les dérivées secondes de l'énergie de surface par rapport à

l'orientation de la surface dans les directions orthogonales associées aux coordonnées x et y.

Selon une variante de l'invention, le coefficient $\alpha_2$ répond à l'équation suivante :

$$\alpha_2 = \frac{\sum_{i=0}^{i=3} c_i \left( \mathrm{Ln}\left[ \frac{\max[f_x ; f_y]}{\min[f_x ; f_y]} \right] \right)^i}{\sum_{i=0}^{i=3} b_i \left( \mathrm{Ln}\left[ \frac{\max[f_x ; f_y]}{\min[f_x ; f_y]} \right] \right)^i}$$

Avec $b_i$ et $c_i$ des constantes.

Selon une variante de l'invention, le procédé comprend une étape de recuit permettant de générer l'évolution de surface.

Avantageusement la température de recuit est nettement inférieure à la température de fusion du matériau cristallographique.

Selon une variante de l'invention, la mesure de l'écart G répond à la formule suivante :

$$G = \sum_{fx=fx_min}^{fx_max} \sum_{fy=fy_min}^{fy_max} \left( PSD(fx,fy,t) - PSD(fx,fy,0) * a(t)^2 \right)^2$$

avec *PSD (fx,fy,t)* la densité spectrale de puissance égale au carré de la norme de la transformée de Fourier au temps t H(fx,fy,t) et *PSD* (fx,fy,0) la densité spectrale de puissance au temps $t_0$ égale au carré de la norme de la transformée de Fourier au temps $t_0$=0, H(fx,fy,0).

Selon une variante de l'invention, la mesure de l'écart G' répond à la formule suivante :

$$G' = \sum_{fx=fx_min}^{fx_max} \sum_{fy=fy_min}^{fy_max} \left( \|H(fx,fy,t)\| - \|H(fx,fy,0)\| * a(t) \right)^2$$

avec $\|H(fx, fy, t)\|$ : la norme de la transformée de Fourier aux fréquences fx et fy et au temps t. $\|H(fx,fy,0)\|$ : la norme de la transformée de Fourier aux fréquences fx et fy et au temps initial au temps $t_0$=0.

Selon une variante de l'invention, la mesure de topologie est de type microscopie à force atomique couramment dénommée AFM.

Selon une variante de l'invention, la mesure de topologie est de type profilomètrie optique.

Selon une variante de l'invention, la mesure de topologie est de type microscopie confocale.

Selon une variante de l'invention, la mesure de topologie est faite par microscope à effet tunnel.

Selon une variante de l'invention, le procédé comporte en outre une étape préalable de génération de rugosités surfaciques.

Selon une variante de l'invention, la génération de rugosités est réalisée par attaque chimique.

Selon une variante de l'invention, la génération de rugosités est réalisée par gravure plasma.

Selon une variante de l'invention, la génération de rugosités est réalisée par attaque électrolytique.

Selon une variante de l'invention, la génération de rugosités est réalisée par indentation ou nano-indentation. De manière générale, en technologie, l'indentation de la surface d'un matériau entraine des modifications locales de la topologie.

L'invention sera mieux comprise et d'autres avantages apparaîtront à la lecture de la description qui va suivre donnée à titre non limitatif.

L'invention s'appuie sur le fait que dans le cas des petites ou des moyennes perturbations, le phénomène d'évolution surfacique est linéaire. Cela signifie que si la surface initiale (au temps $t_0$=0) peut se mettre sous la forme

$$z(x,y) = \sum_j a_j \cdot f_j(x,y) \qquad \text{[eq . 1.1]}$$

et que si l'évolution temporelle de chaque $f_j(x,y)$ individuel peut se mettre sous la forme $F_j(x,y,t)$, alors la surface à un temps t quelconque peut s'écrire:

$$z(x,y,t) = \sum_j a_j \cdot F_j(x,y,t) \qquad \text{[eq . 1.2]}$$

Cette propriété permet de faire une décomposition de la surface en série de Fourier 2D. Il suffit donc de calculer l'évolution d'une surface d'équation initiale (à t=0) :

$$F(x,y,0) = a_0 \cdot Cos[2\pi x.f_x] \cdot Cos[2\pi y.f_y] \qquad \text{[eq . 1.3]}$$

avec : $a_0$ amplitude initiale de la perturbation associée aux longueurs d'ondes $\lambda_X$ et $\lambda_y$ ;
$\lambda_x$ : longueur d'onde en x et $\lambda_y$ : longueur d'onde en y
A un déphasage en $f_x$ et/ou en $f_y$ près (qui se traduit ici par un décalage en x et/ou en y), toutes les composantes de la décomposition en série de Fourier peuvent s'écrire sous cette forme.

L'hypothèse des petites perturbations revient à supposer que $a_0 << \lambda_x$ et $a_0 << \lambda_y$ et l'on considère par ailleurs que les directions propres du tenseur de diffusion sont parallèles aux axes x et y.

Dans le cadre de l'invention et pour des perturbations dites « moyennes », on considère que l'équation suivante est validée dès que :

$$\text{Max } (a_0/\lambda_x,\ a_0/\lambda_y) < 0{,}3$$

Dans ces conditions, la demanderesse a établi que si les directions propres du tenseur de diffusion sont parallèles aux axes x et y, l'évolution temporelle de la surface peut s'écrire :

$$F(x,y,t) = a(t) \cdot Cos\ [2\pi x.f_x] \cdot Cos\ [2\pi y.f_y] \qquad \text{[eq . 1.4.]}$$

Soit encore à partir de l'équation valable dans le cas des petites perturbations :

$$a(t) = a_0 \cdot Exp\left[-C \cdot \left(d_x f_x^2 + d_y f_y^2\right)\left(\left(\gamma_o + \gamma_x''\right).f_x^2 + \left(\gamma_o + \gamma_y''\right).f_y^2\ \right) \cdot t\right]$$

$$\text{[eq.1.5]}$$

Avec : $d_x$ : coefficient de diffusion dans la direction x ;
$d_y$ : coefficient de diffusion dans la direction y ;
$\gamma_o$ : énergie de surface moyenne dans la direction normale au plan (x,y)
$\gamma_x''$ (respectivement $\gamma_y''$ ) : dérivée seconde de l'énergie de surface par rapport à l'orientation de la surface dans les directions associées aux coordonnées x (respectivement y)
C : coefficient physique ne dépendant que des propriétés atomiques de la surface et de la température:

$$C = \frac{16 * n_s * \pi^4 * \Omega_o^2}{k_B * T} \quad \text{[eq .1.6]}$$

où, comme précédemment, $n_s$ est le nombre d'atomes de surface par unité de surface, $k_BT$ est l'énergie thermique, $\Omega_o$ est le volume atomique. Connaissant la structure cristallographique du matériau et l'orientation cristallographique moyenne de la surface, il est possible d'estimer numériquement le coefficient C.

On constate donc que la quantité :

$$\left[C\left(d_x f_x^2 + d_y f_y^2\right)\left(\left(\gamma_o + \gamma_x''\right).f_x^2 + \left(\gamma_o + \gamma_y''\right).f_y^2\right)\right]$$

peut être considérée comme l'inverse d'un temps caractéristique théorique $\tau$ théorique de décroissance de cette perturbation.

$$a(t) = a_0 \exp\left[-\frac{t}{\tau_{\text{théorique}}}\right] \quad \text{[eq. 1.7]}$$

avec

$$\tau_{\text{théorique}} = \frac{1}{C\left(d_x f_x^2 + d_y f_y^2\right)\left(\left(\gamma_o + \gamma_x''\right).f_x^2 + \left(\gamma_o + \gamma_y''\right).f_y^2\right)} \quad \text{[eq. 1.8]}$$

Pour s'affranchir de l'hypothèse des petites perturbations, la demanderesse a démontré qu'il est possible en utilisant un logiciel scientifique de simulation numérique construit sur les mêmes bases que celles décrites dans les articles de E. Dornel " Évolution morphologique par diffusion de surface et application à l'étude du démouillage de films minces solides", thèse de l'Université Joseph Fourier, Grenoble, 09/11/2007 E. Dornel & al, "Surface diffusion dewetting of thin solid films: Numerical methods and application to Si/SiO2", Physical Review B, 73, 115427, 2006, mais qui traite l'évolution de surface 3D et tant que les ratios de l'amplitude initiale $a_0$ de la perturbation divisée par ses longueurs d'onde $\lambda_x$ en x et en $\lambda_y$ en y restent inférieur à 0.3 ($a_0/\lambda_x<0.3$ et $a_0/\lambda_y<0.3$), d'exprimer la dérivée temporelle de l'amplitude en fonction de cette amplitude a(t), du temps caractéristique théorique $\tau_{\text{théorique}}$ et des ratios $a(t)/\lambda_x$ et $a(t)/\lambda_y$ par la formule :

$$\frac{\partial a(t)}{\partial t} = -\frac{1 + \alpha_2 \max\left[a(t).f_x ; a(t).f_y\right]^2}{\tau_{\text{théorique}}} a(t)$$

[eq. 1.9]

Où le coefficient $\alpha_2$ ne dépend que de $\lambda_x$ et $\lambda_y$ suivant la formule [eq.1.11] décrite plus loin.

L'équation différentielle ci-dessus s'intègre et on obtient la formule suivante, valable aussi bien pour les petites perturbations que les moyennes perturbations :

$$a(t) = \frac{a_o}{\sqrt{1 + a_0^2\alpha_2\,(\max(f_x;f_y))^2} \cdot \sqrt{\exp\left(\frac{2t}{\tau_{théorique}}\right) - \frac{a_0^2\alpha_2\,(\max(f_x;f_y))^2}{1 + a_0^2\alpha_2\,(\max(f_x;f_y))^2}}}$$

[eq. 1.10]

où $a_0$ est la valeur de l'amplitude a(t) pour t=0 : $a_0$=a(0). On vérifie bien qu'on retrouve la formule des petites perturbations quand $a_0/\lambda_x$ et $a_0/\lambda_y$ sont petits devant 1.

Le coefficient $\alpha_2$ ne dépend que de $\lambda_x$ et $\lambda_y$, ou, ce qui est équivalent, de $f_x=1/\lambda_x$ et $f_y=1/\lambda_y$. La demanderesse a effectué un grand nombre de calculs pour des valeurs de $\lambda_x$ et $\lambda_y$ telles que $1/30<\lambda_x/\lambda_y<30$ et des valeurs de $a_0/\lambda_x$ et $a_0/\lambda_y$ entre 0.0005 et 0.30 et a constaté que ce coefficient suit avec une très bonne approximation la formule :

$$\alpha_2 = \frac{\sum_{i=0}^{i=3} c_i \left( \mathrm{Ln}\left[ \frac{\max[f_x;f_y]}{\min[f_x;f_y]} \right] \right)^i}{\sum_{i=0}^{i=3} b_i \left( \mathrm{Ln}\left[ \frac{\max[f_x;f_y]}{\min[f_x;f_y]} \right] \right)^i} \qquad \text{[eq. 1.11]}$$

Ln représente le logarithme Népérien Les coefficients $c_i$ et $b_i$ ont des valeurs numériques voisines de celles qui sont présentées dans le tableau suivant :

| i | 0 | 1 | 2 | 3 |
|---|---|---|---|---|
| ci | 78.0309 | 70.7353 | 102.025 | 169.520 |
| bi | 1.000 | 1.76088 | 0.000 | 1.60881 |

L'invention proposée consiste à utiliser ce résultat pour :

- soit estimer les deux composantes $d_x$ et $d_y$ du tenseur de diffusion (par rapport à l'orientation de la surface dans les directions associées aux coordonnées x et y), connaissant l'énergie de surface $\gamma_o$ et ses dérivées secondes $\gamma_x$" et $\gamma_y$" en x et y (ou seulement $\gamma_o$ si on peut faire l'hypothèse que l'énergie de surface est isotrope).
- soit estimer les sommes $\gamma_o + \gamma_x$" et $\gamma_o + \gamma_y$" (énergies de surfaces anisotropes), connaissant les deux composantes $d_x$ et $d_y$ du tenseur de diffusion (ou seulement le coefficient de diffusion scalaire $D_s$ si on peut faire l'hypothèse que la diffusion de surface est isotrope).
- soit estimer simultanément les 3 quantités ci-dessous et n'importe quelle combinaison de ces 3 quantités : dx* ($\gamma_o$+ $\gamma_x$" ) , dy*( $\gamma_o$+ $\gamma_y$" ), dy* ($\gamma_o + \gamma_x$" )+ dx*( $\gamma_o + \gamma_y$").

Ainsi, selon l'invention :

- On procède dans une première étape à une mesure de la topologie initiale au temps $t_0$=0 d'une surface rugueuse (présentant des rugosités dont le ratio amplitude/longueur d'onde est inférieur à environ 0,3) en localisant précisément la zone mesurée. Plusieurs techniques de profilomètrie existent et sont connues de l'homme de l'art. La plus classique pour des surfaces et des rugosités de petites dimensions est le microscope à force atomique (AFM) ou l'une de ses nombreuses variantes. On peut aussi utiliser le microscope à effet tunnel ou la profilomètrie optique ou un microscope confocal. Il convient généralement de procéder à des corrections des mesures brutes selon des techniques également connues de l'homme de l'art.
- Dans une seconde étape, on fait évoluer la surface par diffusion de surface. Ceci peut typiquement être réalisé par

une opération de recuit d'un temps t à une température T, assez élevée mais nettement inférieure à la température de fusion.

- Dans une troisième étape, on procède à nouveau à une mesure de topologie de surface de la même zone (donc en cours de perturbation) que celle mesurée précédemment.

On dispose alors de deux topologies de la même surface avant et après recuit.
On réalise une transformée de Fourier 2D de ces deux topologies. On peut typiquement pour ce faire utiliser des techniques décrites dans le livre W.H.Press & al, »Numerical Recipes, the art of scientific computing », 3rd edition, Cambridge University Press, 2007.
Cette transformée de Fourier est considérablement facilitée si la mesure est faite sur un réseau carré de points (x, y) et si le nombre de mesures dans chaque direction est une puissance de 2. On peut alors utiliser les méthodes classiques de transformée de Fourier rapide. Ceci est très souvent le cas pour des mesures par AFM ou pour d'autres méthodes de profilomètrie.
Ces transformées de Fourier, en particulier celle avant recuit, permettent notamment de quantifier l'amplitude initiale $a_0$ de la perturbation considérée de chaque composante en fréquence fx et fy ou en longueurs d'onde λx et λy, et donc de vérifier si les conditions $a_0 / \lambda x < 0,3$ et $a_0 / \lambda_y < 0,3$ sont bien vérifiées.
Selon une première variante de l'invention, on s'intéresse au carré de la norme de la transformée de Fourier 2D, généralement connue sous le nom de densité spectrale de puissance (encore dénommée Power Spectral Density et introduit sous l'acronyme « PSD »). On est ainsi amené à considérer la quantité G suivante :

$$G = \sum_{fx=fx_min}^{fx_max} \sum_{fy=fy_min}^{fy_max} \left(PSD(fx, fy, t) - PSD(fx, fy, 0) * a(t)^2\right)^2$$

La double somme définissant G se fait sur l'ensemble des fréquences $fx = 1/\lambda_x$ et $fy = 1/\lambda_y$ présentes dans la transformée de Fourier 2D. PSD(fx,fy,t) est la valeur de la PSD au temps t, PSD(fx,fy,0) est la valeur initiale de la PSD (au temps de référence $t_0=0$) et a(t) répondant à l'équation [eq. 1.10]
Cette option de mode de réalisation présente l'avantage d'être un peu plus proche de ce à quoi sont souvent habitués les utilisateurs de profilométrie, qui peuvent utiliser la PSD pour définir la rugosité RMS.

- Si on cherche les deux composantes du tenseur de diffusion connaissant les énergies de surface et leurs dérivées secondes en x et en y (c'est-à-dire connaissant les quantités $\gamma_o + \gamma_x''$ et $\gamma_o + \gamma_y''$), alors le mode de réalisation consiste à rechercher les valeurs de dx et dy qui minimisent la quantité G.
- Si on cherche les deux quantités $\gamma_o + \gamma_x''$ et $\gamma_o + \gamma_y''$ connaissant les deux composantes dx et dy du tenseur de diffusion, alors le mode de réalisation consiste à rechercher les valeurs des deux quantités $\gamma_o + \gamma_x''$ et $\gamma_o + \gamma_y''$ qui minimisent la quantité G.
- Si on cherche les 3 quantités $dx^* (\gamma_o + \gamma_x'')$ ; $dy^*(\gamma_o + \gamma_y'')$ et $dy^* (\gamma_o + \gamma_x'') + dx^*(\gamma_o + \gamma_y'')$ , alors le mode de réalisation consiste à rechercher les valeurs de ces trois quantités qui minimisent la quantité G :

$$G = \sum_{fx=fx_min}^{fx_max} \sum_{fy=fy_min}^{fy_max} \left(PSD(fx, fy, t) - PSD(fx, fy, 0) * a(t)^2\right)^2 .$$

Dans les trois cas mentionnés ci-dessus, les méthodologies numériques à mettre en oeuvre pour déterminer les quantités recherchées qui minimisent la quantité G sont connues de l'homme de l'art et notamment décrites dans le livre de W. H. Press & al, "Numerical Recipes, the art of scientific computing", 3rd édition, Cambridge University Press, 2007. On peut, entre autre, citer la méthode de Levenberg-Marquardt (p. 801 chapitre 15.5.2), les méthodes faisant intervenir le gradient et la matrice Hessienne (p.800 chapitre 15.5.1), les méthodes du Simplex (p. 502 chapitre 10.5), la méthode de Powell (p.509 chapitre 10.7).
Selon une seconde variante de l'invention, le procédé utilise non pas le carré de la norme de la transformée de Fourier, mais directement cette norme elle-même. Soit donc la quantité G' définie par :

$$G' = \sum_{fx=fx_min}^{fx_max} \sum_{fy=fy_min}^{fy_max} \left( \|H(fx,fy,t)\| - \|H(fx,fy,0)\| * a(t) \right)^2$$

De la même manière, la double somme définissant G' se fait sur l'ensemble des fréquences fx = $1/\lambda_x$ et fy = $1/\lambda_y$ présentes dans la transformée de Fourier 2D.
$\| H(fx,fy,t)\|$ est la norme de la transformée de Fourier aux fréquences fx et fy et au temps t.
$\| H(fx,fy,0)\|$ est la norme de la transformée de Fourier aux fréquences fx et fy et au temps initial $t_0$=0.

- Si on cherche les deux composantes du tenseur de diffusion connaissant les énergies de surface et leurs dérivées secondes en x et en y (c'est-à-dire connaissant les quantités $\gamma_o + \gamma_x''$ et $\gamma_o + \gamma_y''$), alors le mode de réalisation consiste à rechercher les valeurs de dx et dy qui minimisent la quantité G'.
- Si on cherche les deux quantités $\gamma_o + \gamma_x''$ et $\gamma_o + \gamma_y''$ connaissant les deux composantes dx et dy du tenseur de diffusion, alors le mode de réalisation consiste à rechercher les valeurs des deux quantités $\gamma_o + \gamma_x''$ et $\gamma_o + \gamma_y''$ qui minimisent la quantité G'.
- Si on cherche les 3 quantités $dx^*(\gamma_o + \gamma_x'')$ ; $dy^*(\gamma_o + \gamma_y'')$ et $dy^*(\gamma_o + \gamma_x'') + dx^*(\gamma_o + \gamma_y'')$, alors le mode de réalisation consiste à rechercher les valeurs de ces trois quantités qui minimisent la quantité G'.

Dans les cas ci-dessus, les méthodologies numériques à mettre en oeuvre pour déterminer les quantités recherchées qui minimisent G' sont connues de l'homme de l'art, et peuvent être similaires à celles citées dans la variante précédente concernant la quantité G.

Pour de nombreuses applications liées à la prévision de l'évolution topologique d'une surface, il n'est pas nécessaire de connaître directement les énergies de surface ou les composantes du tenseur de diffusion, mais seulement les quantités :

$$C^*dx^*(\gamma_o + \gamma_x'') \; ; \; C^*dy^*(\gamma_o + \gamma_y'') \; ; \; C^*(dy^*(\gamma_o + \gamma_x'') + dx^*(\gamma_o + \gamma_y''))$$

Dans ces applications de l'invention, il n'est donc pas nécessaire de connaître numériquement la valeur du coefficient C. Il est possible (en utilisant l'une ou l'autre des deux options décrites ci-dessus) de minimiser la quantité G ou G' pour estimer les 3 grandeurs utiles ci-dessus incluant déjà le coefficient C.

Cela permet de s'affranchir de la nécessité de connaître les paramètres suivants : le nombre d'atomes de surface par unité de surface $n_s$ et le volume atomique $\Omega_o$.

Le procédé de l'invention permet par ailleurs des mesures très localisées de tenseur de diffusion ou d'énergies de surfaces. Pour ce faire, on peut utiliser des techniques d'indentation ou de nano-indentation pour réaliser localement une ou plusieurs empreintes d'indentation ou de nano-indentation.

On procède alors selon le procédé de l'invention à une première mesure de topologie après cette indentation ou cette nano-indentation, puis on fait évoluer l'état de surface par exemple par une opération de recuit permettant de générer de la diffusion de surface. On procède alors à une seconde mesure de topologie pour procéder à la détermination du tenseur de diffusion ou des énergies de surfaces suivant la méthode décrite précédemment.

Il est à noter que la présente invention présente l'avantage de ne pas nécessiter la fabrication de dispositifs spéciaux pour mesurer les anisotropies du tenseur de diffusion de surface ou de l'énergie de surface. On peut utiliser une surface naturellement rugueuse, telle que par exemple les surfaces après fractures.

Par ailleurs, on peut aussi utiliser des surfaces rendues artificiellement rugueuses. Il est en effet assez facile de rendre volontairement, et de manière contrôlée, rugueuses des surfaces initialement lisses. Ceci peut se faire par attaque chimique, par gravure plasma, par attaque électrolytique. Ces méthodes sont connues de l'homme de l'art et sont assez faciles à mettre en oeuvre.

La mise en oeuvre du procédé de mesure de l'invention requiert des outils de mesures de la topologie de surface classiques ainsi qu'également des méthodes numériques classiques permettant de disposer d'instrument type AFM intégrant un logiciel mettant en oeuvre ledit procédé de mesure.

Avec ce type d'instrument, on peut typiquement mesurer localement l'anisotropie de diffusion ou d'énergie d'une surface. La taille de la zone mesurée est directement la taille à l'échelle de laquelle on connaîtra cette anisotropie. Par exemple, dans le cas d'un AFM, cette taille est typiquement un carré de 1 à 10 $\mu$m de coté.

## Revendications

1. Procédé de mesure d'un tenseur anisotrope de diffusion de surface ou des anisotropies d'énergie de surface, d'une surface définie par une fonction z (x,y) dépendante de deux coordonnées (x,y) selon deux directions orthogonales, la transformée de Fourier de cette surface permettant de la décomposer en une somme de perturbations dites de moyenne amplitude d'amplitude initiale ($a_0$) et de longueurs d'onde ($\lambda_x$, $\lambda_y$), les ratio amplitude/longueurs d'onde ($a_0/\lambda_x$ ; $a_0/\lambda_y$ ) étant inférieurs à environ 0,3), **caractérisé en ce qu'**il comprend les étapes suivantes :

   - une première mesure de la topologie de surface permettant de déterminer la transformée de Fourier H(fx,fy, 0) de cette première topologie à un instant $t_0$=0, fx et fy étant les fréquences spatiales ;
   - une étape d'évolution de ladite surface par diffusion de surface ;
   - une seconde mesure de la topologie de surface après évolution de ladite surface permettant de déterminer la transformée de Fourier H(fx,fy,t) de cette seconde topologie à un instant t, fx et fy étant les fréquences spatiales ;
   - la détermination de composantes du tenseur de diffusion ou des dérivées secondes de l'énergie de surface ou d'une combinaison des composantes du tenseur et des dérivées secondes de l'énergie de surface, permettant de minimiser une mesure (G, G') de l'écart entre une grandeur H(fx,fy,t) et une grandeur H(fx,fy,0).a(t), avec

$$a(t) = \frac{a_o}{\sqrt{1+a_0^2\alpha_2\left(\max(f_x;f_y)\right)^2}\cdot\sqrt{\exp\left(\frac{2t}{\tau_{théorique}}\right)-\frac{a_0^2\alpha_2\left(\max(f_x;f_y)\right)^2}{1+a_0^2\alpha_2\left(\max(f_x;f_y)\right)^2}}}$$

   $\alpha_2$ dépendant de fx et fy, fx et fy étant les fréquences spatiales dans les directions orthogonales associées aux coordonnées x et y. et

$$\tau_{théorique} = \frac{1}{C\left(d_x f_x^2 + d_y f_y^2\right)\left(\left(\gamma_o+\gamma_x''\right).f_x^2+\left(\gamma_o+\gamma_y''\right).f_y^2\ \right)}$$

   et $d_x$ et $d_y$ : des composantes du tenseur de diffusion relatif à l'anisotropie de diffusion dans les directions respectivement x et y, $\gamma_0$ l'énergie de surface et $\gamma_x''$, $\gamma_y''$ les dérivées secondes de l'énergie de surface par rapport à l'orientation de la surface dans les directions associées aux coordonnées x et y.

2. Procédé de mesure d'un tenseur anisotrope de diffusion de surface ou des anisotropies d'énergie de surface selon la revendication 1, **caractérisé en ce que** le coefficient $\alpha_2$ répond à l'équation suivante :

$$\alpha_2 = \frac{\sum_{i=0}^{i=3} c_i\left(\mathrm{Ln}\left[\frac{\max\left[f_x;f_y\right]}{\min\left[f_x;f_y\right]}\right]\right)^i}{\sum_{i=0}^{i=3} b_i\left(\mathrm{Ln}\left[\frac{\max\left[f_x;f_y\right]}{\min\left[f_x;f_y\right]}\right]\right)^i}$$

   ci et bi étant des constantes .

3. Procédé de mesure d'un tenseur anisotrope de diffusion de surface ou des anisotropies d'énergie de surface selon l'une des revendications 1 ou 2, **caractérisé en ce que** la mesure de l'écart (G) répond à la formule suivante :

$$G=\sum_{fx=fx_min}^{fx_max}\sum_{fy=fy_min}^{fy_max}\left(PSD(fx,fy,t)-PSD(fx,fy,0)*a(t)^{2}\right)^{2}$$

et *PSD* (fx,fy,t) la densité spectrale de puissance correspondant au carré de la norme de la transformée de Fourier au temps t et *PSD* (fx,fy,0) la densité spectrale de puissance au temps $t_0$ .

**4.** Procédé de mesure d'un tenseur anisotrope de diffusion de surface ou des anisotropies d'énergie de surface selon l'une des revendications 1 ou 2, **caractérisé en ce que** la mesure de l'écart (*G*') répond à la formule suivante :

$$G'=\sum_{fx=fx_min}^{fx_max}\sum_{fy=fy_min}^{fy_max}\left(\|H(fx,fy,t)\|-\|H(fx,fy,0)\|*a(t)\right)^{2}$$

avec $\|H(fx, fy, t)\|$ la norme de la transformée de Fourier aux fréquences fx et fy et au temps t, $\|H(fx,fy,0)\|$ est la norme de la transformée de Fourier aux fréquences fx et fy et au temps initial $t_0$=0.

**5.** Procédé de mesure d'un tenseur anisotrope de diffusion de surface ou des anisotropies d'énergie de surface selon l'une des revendications 3 ou 4, **caractérisé en ce que** la mesure de l'écart (G, G') est obtenue par une méthode de type méthode de Levenberg-Marquardt ou par une méthode faisant intervenir le gradient et la matrice Hessienne ou par la méthode du Simplex ou par la méthode de Powell.

**6.** Procédé de mesure d'un tenseur anisotrope de diffusion de surface ou des anisotropies d'énergie de surface selon l'une des revendications 1 à 5, **caractérisé en ce que,** la mesure de topologie est de type AFM.

**7.** Procédé de mesure d'un tenseur anisotrope de diffusion de surface ou des anisotropies d'énergie de surface selon l'une des revendications 1 à 5, **caractérisé en ce que,** la mesure de topologie est de type profilomètrie optique.

**8.** Procédé de mesure d'un tenseur anisotrope de diffusion de surface ou des anisotropies d'énergie de surface selon l'une des revendications 1 à 5, **caractérisé en ce que,** la mesure de topologie est de type microscopie confocale.

**9.** Procédé de mesure d'un tenseur anisotrope de diffusion de surface ou des anisotropies d'énergie de surface selon l'une des revendications 1 à 8, **caractérisé en ce qu'**il comporte en outre une étape préalable de génération de rugosités surfaciques.

**10.** Procédé de mesure d'un tenseur anisotrope de diffusion de surface ou des anisotropies d'énergie de surface selon la revendication 9, **caractérisé en ce que** la génération de rugosités est réalisée par attaque chimique.

**11.** Procédé de mesure d'un tenseur anisotrope de diffusion de surface ou des anisotropies d'énergie de surface selon la revendication 9, **caractérisé en ce que** la génération de rugosités est réalisée par gravure plasma.

**12.** Procédé de mesure d'un tenseur anisotrope de diffusion de surface ou des anisotropies d'énergie de surface selon la revendication 9, **caractérisé en ce que** la génération de rugosités est réalisée par attaque électrolytique.

**13.** Procédé de mesure d'un tenseur anisotrope de diffusion de surface ou des anisotropies d'énergie de surface selon la revendication 9, **caractérisé en ce que** la génération de rugosités est réalisée par indentation ou nano-indentation.

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

### Littérature non-brevet citée dans la description


- **W. W. Mullins.** Flattening of a Nearly Plane Solid Surface due to Capillarity. *J. of Applied Physics,* 1959, vol. 30 (1), 77-83
- Surface tension as a motivation for sintering. **C. Herring.** Physics of powder metallurgy. Mc Graw-Hill, 1951
- **C. Herring.** Surface tension as a motivation for sintering'', in ''Physics of powder metallurgy. Mc Graw-Hill, 1951
- **E Dornel.** Évolution morphologique par diffusion de surface et application à l'étude du démouillage de films minces solides. *thèse de l'Université Joseph Fourier,* 09 Novembre 2007
- **W.W. Mullins.** Theory of thermal Grooving. *J. of Applied Physics,* Mars 1957, vol. 28 (3
- **E. Dornel.** Surface diffusion dewetting of thin solid films: Numerical methods and application to Si/SiO2. *Physical Review B,* 2006, vol. 73, 115427
- **E. Dornel.** Évolution morphologique par diffusion de surface et application à l'étude du démouillage de films minces solides. *thèse de l'Université Joseph Fourier,* 09 Novembre 2007
- **W.H.Press.** Numerical Recipes, the art of scientific computing. Cambridge University Press, 2007
- **W. H. Press.** Numerical Recipes, the art of scientific computing. Cambridge University Press, 2007